# FASCICULE DE BREVET EUROPEEN

(11) **EP 1 289 122 B1**
(45) Date de publication et mention de la délivrance du brevet: **09.02.2005**
(21) Numéro de dépôt: 01202654.8
(22) Date de dépôt: 10.07.2001
(51) Int. Cl.: H03C 1/54

(54) **Modulateur équilibré en quadrature à double conversion de fréquence**
Symmetrischer Quadraturmodulator unter Verwendung von zweistufiger Frequenzumsetzung
Balanced quadrature modulator with double frequency conversion

(43) Date de publication de la demande: 05.03.2003
(73) Titulaire: ASULAB S.A., 2074 Marin (CH)
(72) Inventeur: Casagrande, Arnaud, 2523 Lignières (CH)
(74) Mandataire: Surmely, Gérard

(56) Documents cités:
- EP-A- 0 998 024
- US-A- 5 373 265
- US-A- 5 847 623
- US-A- 5 861 781
- US-A- 6 029 059

## Description

La présente invention concerne un modulateur en quadrature à double conversion de fréquence, utilisé notamment dans des circuits émetteurs pour la téléphonie mobile. Le modulateur à double conversion comprend un premier étage de conversion de fréquence formé par un premier bloc de modulation. Ce premier bloc de modulation reçoit en entrée des signaux quadriphasés en bande de base, constitués par un premier signal en phase, un deuxième signal en opposition de phase, un troisième signal en quadrature et un quatrième signal en opposition de quadrature. Ce premier bloc est commandé par des signaux porteurs quadriphasés à une première fréquence intermédiaire constitués par un premier signal porteur en phase, un deuxième signal porteur en opposition de phase, un troisième signal porteur en quadrature et un quatrième signal porteur en opposition de quadrature. En sortie, ce bloc de modulation délivre un signal converti à la première fréquence intermédiaire.

Ce genre de modulateur en quadrature à conversion simple, constitué d'un seul bloc de modulation, est largement connu dans l'art antérieur voir par exemple le document US 6 029 059 A. Le modulateur, tel que représenté à la figure 1, comprend deux mélangeurs différentiels 10 et 12. Le premier mélangeur 10 reçoit en entrée un signal en bande de base en phase bbl et le second mélangeur 12 reçoit en entrée un signal en bande de base en quadrature bbQ. Les deux mélangeurs 10 et 12 sont commandés par des signaux porteurs haute fréquence HF_I et HF_Q obtenus par un générateur de signaux haute fréquence en quadrature, non représenté. Le premier mélangeur 10 est commandé par un signal porteur haute fréquence en phase HF_I. Le second mélangeur 12 est commandé par un signal porteur haute fréquence en quadrature HF_Q, soit un signal déphasé de 90° par rapport au signal porteur HF_I. Les signaux délivrés en sortie des mélangeurs 10 et 12 sont des signaux modulés en quadrature à la fréquence des signaux porteurs. Un additionneur 14 placé en sortie du modulateur somme les deux signaux modulés pour fournir le signal modulé haute fréquence HF_M en sortie.

L'inconvénient d'un tel modulateur à conversion simple réside dans la nécessité de produire des signaux porteurs haute fréquence HF_I et HF_Q parfaitement en quadrature. Un tel générateur de signaux s'avère rapidement complexe sans pouvoir pour autant assurer un déphasage de 90° avec une précision suffisante. De plus, la consommation d'un tel générateur est assez importante.

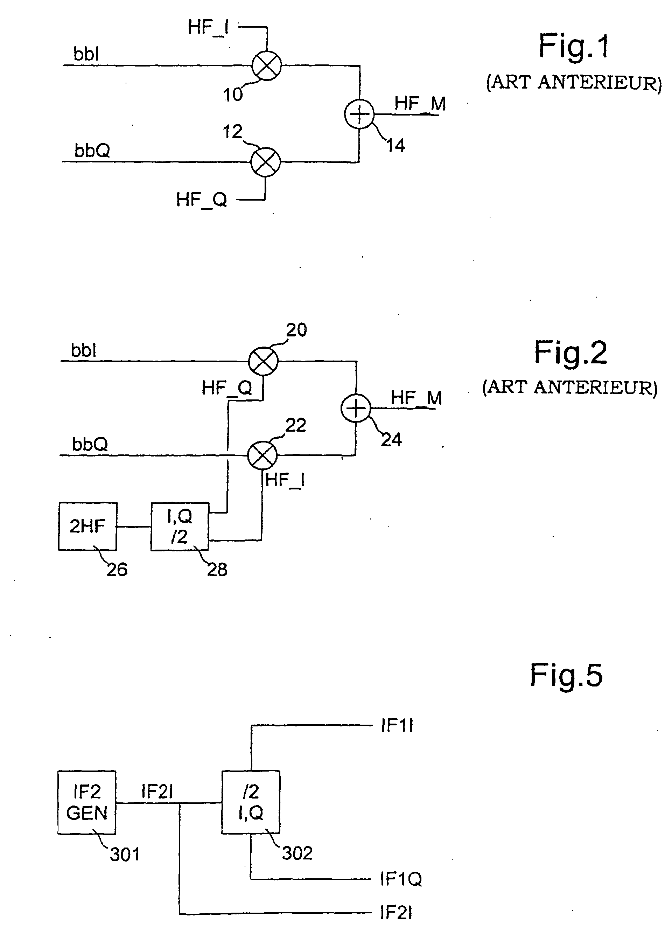

Un autre type de modulateur en quadrature à conversion simple connu de l'art antérieur est représenté à la figure 2. Ce modulateur fonctionne exactement sur le même principe que celui sus présenté. La différence avec le modulateur précédent se situe dans la génération des signaux porteurs en quadrature à haute fréquence HF_I et HF_Q. Ici, un générateur de signaux haute fréquence 26 est utilisé pour générer des signaux porteurs à une fréquence double 2HF de celle désirée pour le signal modulé de sortie. Un diviseur de fréquence par deux en quadrature 28 est placé en sortie du générateur 26, ce qui permet d'obtenir des signaux porteurs HF_I et HF_Q parfaitement en quadrature à la fréquence de modulation HF désirée pour commander les mélangeurs différentiels 20 et 22 du modulateur.

L'inconvénient de ce type de modulateur (voir aussi le document US 5 373 265 A) réside dans la consommation excessive du générateur haute fréquence 26, utilisé pour produire des signaux à une fréquence double de celle désirée. En effet, pour des fréquences de l'ordre du GHz, comme par exemple 900 MHz (domaine de la téléphonie mobile), il est nécessaire que le générateur produise des signaux à une fréquence de 1,8 GHz.

L'un des soucis permanent de l'homme du métier est de réaliser des circuits à faible consommation, ceux-ci étant généralement intégrés dans des outils de communication portables, tout en obtenant une qualité optimale de modulation en quadrature des signaux.

L'invention est remarquable en ce qu'elle permet d'éviter les inconvénients susmentionnés.

Pour cela, la présente invention concerne un modulateur à double conversion, tel que défini en préambule caractérisé en ce que le premier étage est formé en outre d'un deuxième bloc de modulation, similaire au premier bloc,
- recevant en entrée lesdits premier, deuxième, troisième et quatrième signaux en bande de base,
- commandé par lesdits premier, deuxième, troisième et quatrième signaux porteurs à ladite première fréquence intermédiaire et
- délivrant en sortie un deuxième signal converti, en opposition de phase audit premier signal converti, à ladite première fréquence intermédiaire,
et en ce que le modulateur comprend en outre un deuxième étage de conversion,
- recevant en entrée lesdits premier et deuxième signaux convertis à ladite première fréquence intermédiaire,
- commandés par deux autres signaux porteurs à une deuxième fréquence intermédiaire, constitués par un cinquième signal porteur en phase et un sixième signal porteur en opposition de phase, et
- délivrant en sortie un signal haute fréquence, ladite haute fréquence correspondant à la somme desdites première et deuxième fréquences intermédiaires.

Le modulateur selon l'invention permet ainsi de réaliser une modulation à basse consommation. En effet, les signaux porteurs utilisés pour transposer la fréquence des signaux d'entrée en bande de base, en un signal de sortie haute fréquence, sont des signaux à des fréquences intermédiaires inférieures à la haute fréquence de modulation en sortie. Ainsi, le générateur utilisé pour fournir ces signaux porteurs consomme d'autant moins d'énergie que la fréquence est moindre.

Un autre souci constant de l'homme du métier est la nécessité de générer des signaux modulés les plus propres possible. Pour cela, il est indispensable d'éliminer tous les signaux parasites ou signaux dits de « feedthrough » qui apparaissent dans les structures non balancées.

C'est pourquoi, selon un mode avantageux de l'invention, le modulateur à double conversion est caractérisé en ce que les deux blocs de modulation du premier étage de conversion comprennent des premier et deuxième mélangeurs différentiels, respectivement, des troisième et quatrième mélangeurs différentiels,
en ce que les premier et deuxième mélangeurs fournissent en sortie, respectivement, des premier et deuxième signaux modulés à la première fréquence intermédiaire (IF1), les premier et deuxième signaux modulés étant sommés en sortie du premier bloc pour obtenir le premier signal converti,
en ce que les troisième et quatrième mélangeurs différentiels fournissent en sortie, respectivement, des troisième et quatrième signaux modulés à la première fréquence intermédiaire, les troisième et quatrième signaux modulés étant sommés en sortie du deuxième bloc pour obtenir le deuxième signal converti, et
en ce que le deuxième étage de conversion est constitué d'un cinquième mélangeur différentiel.

Enfin, dans ce type de modulateur en quadrature, il est très important que les signaux porteurs soient en quadrature et ce avec une grande précision. En effet, notamment dans un domaine tel que la téléphonie mobile où les fréquences de modulation sont de l'ordre du GHz, tout décalage entre les signaux en phase et les signaux en quadrature entraîne l'apparition de signaux parasites supplémentaires.

Dans un mode de réalisation préféré de l'invention, le modulateur à double conversion est caractérisé en ce que les signaux porteurs à la deuxième fréquence intermédiaire commandant le deuxième étage de conversion sont directement générés par un générateur de signaux à la deuxième fréquence intermédiaire et en ce que les signaux porteurs à la première fréquence intermédiaire commandant le premier étage de conversion sont obtenus après division par deux de la fréquence dans un diviseur de fréquence en quadrature placé en sortie du générateur de signaux, la deuxième fréquence intermédiaire étant deux fois plus importante que la première fréquence intermédiaire.

L'invention va être expliquée ci-dessous en détail par un mode d'exécution donné uniquement à titre d'exemple, cette exécution étant illustrée par les dessins annexés parmi lesquels :
- la figure 1 représente un modulateur en quadrature selon un art antérieur ;
- la figure 2 représente un modulateur en quadrature selon un autre antérieur ;
- la figure 3 est une représentation schématique du modulateur selon l'invention ;
- la figure 4 est une représentation détaillée du modulateur selon l'invention ;
- la figure 5 est une représentation du circuit de génération des signaux porteurs.

Les figures 1 et 2 ont déjà été décrites dans le cadre de l'art antérieur.

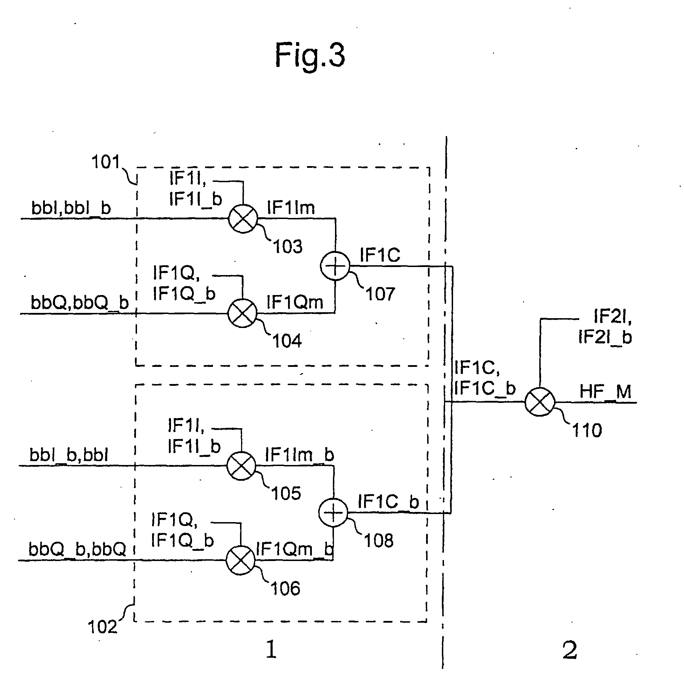

La figure 3 est une représentation schématique du modulateur à double conversion selon l'invention. Le modulateur est décomposé en deux étages dits étages de conversion de fréquence. En effet, le rôle de chacun des deux étages est de moduler et transposer les signaux reçus en entrée à une fréquence supérieure. Plus spécifiquement le premier étage 1 permet de moduler les signaux d'entrée du modulateur à une première fréquence intermédiaire IF1. Les signaux obtenus sont alors « converti » à une fréquence plus grande, ou haute fréquence HF au travers du deuxième étage 2.

L'étage 1 est composé par deux blocs dit de « modulation » 101 et 102. Ces deux blocs sont similaires quant à leur structure interne. La différence entre les deux réside dans les signaux d'entrée et de commande qu'ils reçoivent.

Le premier bloc de modulation 101 est constitué des deux mélangeurs différentiels 103 et 104 et de l'additionneur 107. Le deuxième bloc de modulation 102 est lui constitué des deux mélangeurs différentiels 105 et 106 et de l'additionneur 108. On utilisera de préférence des mélangeurs différentiels formés par un couple de transistors de technologie MOS. L'avantage d'utiliser de tels mélangeurs réside dans l'annulation des signaux parasites ou signaux de feedthrough en sortie du mélangeur. L'annulation de ces signaux de feedthrough est effectivement réalisée si les deux signaux d'entrée et si les deux signaux de commande reçus par le mélangeur sont en opposition de phase.

Le bloc 101 reçoit quatre signaux d'entrée à basse fréquence ou en bande de base. Ces signaux sont quadriphasés. Le mélangeur 103 reçoit en entrée le signal en phase bbl et le signal en opposition de phase bbI_b, et le mélangeur 104 reçoit en entrée le signal en quadrature de phase bbQ et le signal en opposition de quadrature de phase bbQ_b.

Le bloc 101 reçoit également quatre signaux de commande ou signaux porteurs également quadriphasés. Ces signaux porteurs permettent d'effectuer la modulation des signaux en bande de base (bbl, bbl_b, bbQ et bbQ_b) à la fréquence des signaux porteurs. Le mélangeur 103 reçoit le signal porteur en phase IF1I et le signal porteur en opposition de phase IF1I_b. Le mélangeur 104 reçoit le signal porteur en quadrature de phase IF1Q et le signal porteur en opposition de quadrature de phase IF1Q_b. Tous les signaux porteurs sont à la fréquence intermédiaire IF1.

En sortie du bloc 101, est placé un additionneur 107 permettant de sommer les deux signaux modulés IF1Im et IF1Qm, délivrés en sortie par les mélangeurs 103 et 104. Ces deux signaux modulés IF1Im et IF1Qm sont à la fréquence intermédiaire IF1, ainsi le signal dit « converti » IF1C en sortie de l'additionneur 107, et donc en sortie du bloc 101, est à la fréquence intermédiaire IF1. Ce signal IF1C présente l'avantage de ne pas comporter de signaux de feedthrough relatifs notamment aux capacités parasites et aux grandeurs liées aux transistors utilisés dans les mélangeurs différentiels.

Le bloc 102 est constitué, d'une manière totalement similaire au bloc 101, de deux mélangeurs différentiels 105 et 106 et d'un additionneur 108. Les signaux reçus en entrée sont les mêmes quatre signaux quadriphasés en bande de base, et les signaux porteurs de commande sont les mêmes quatre signaux également quadriphasés à la fréquence intermédiaire IF1.

La différence entre les deux blocs 101 et 102 réside dans la combinaison des signaux reçus en entrée avec les signaux de commande. En effet, l'objectif de ce bloc 102 est de fournir en sortie un autre signal converti IF1C_b en opposition de phase du signal converti fourni en sortie du bloc 101.

Pour cela, il suffit d'inverser les signaux en bande de base ou d'inverser les signaux porteurs reçus par chacun des mélangeurs, ce qui est la même chose, les mélangeurs étant symétriques. Cette inversion va entraîner une modification des signaux modulés obtenus en sortie des mélangeurs. Le signal modulé IF1lm_b en sortie du mélangeur 105 est en opposition de phase du signal IF1Im. De même, le signal modulé IF1Qm_b en sortie du mélangeur est en opposition du signal IF1Qm. Ainsi, le signal converti IF1C_b obtenu en sortie de l'additionneur 108 est en opposition de phase du signal converti IF1C.

En sortie de l'étage de conversion 1, on a donc deux signaux convertis en opposition IF1C et IF1C_b à la fréquence intermédiaire IF1. Ces deux signaux convertis sont fournis à l'étage de conversion 2.

Il est à noter que dans cet exemple de réalisation, les signaux convertis en opposition l'un de l'autre sont obtenus par des blocs 101 et 102 semblables, mais il est toutefois possible d'envisager d'utiliser d'autres moyens que le bloc miroir 102 pour obtenir le signal converti en opposition IF1C_b, comme par exemple un déphaseur de 180°.

L'étage 2 est constitué d'un seul mélangeur différentiel 110 recevant en entrée les signaux convertis IF1C et IF1C_b à la fréquence intermédiaire IF1. Le mélangeur 110 est commandé par deux signaux porteurs en opposition de phase IF21 et IF21_b, à la fréquence intermédiaire IF2. Le signal modulé HF_M obtenu en sortie du mélangeur 110 correspond aux signaux reçus en entrée mais transposés en fréquence ou « up-converted ». En effet, le signal modulé HF_M est un signal haute fréquence, dont la fréquence HF est égale à la somme des fréquences intermédiaires IF1 + IF2.

L'utilisation d'un mélangeur différentiel pour réaliser la transposition de fréquence ou « up-conversion » permet non seulement d'éliminer notamment les signaux de feedthrough dus aux capacités parasites des transistors constituant le mélangeur 110, mais aussi d'éliminer les signaux aux fréquences parasites intermédiaires IF1 et IF2.

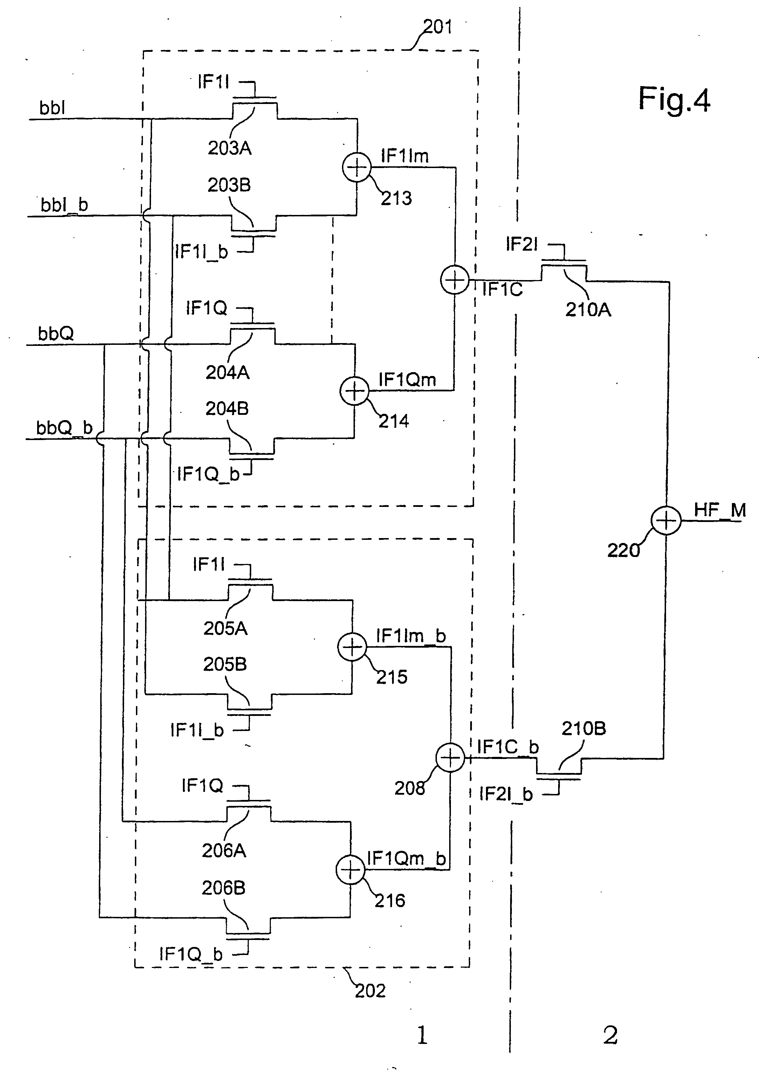

La figure 4 représente de manière détaillée un modulateur à double conversion selon l'invention. La structure globale du modulateur a déjà été décrite dans le cadre de la figure 3. Ainsi, on retrouve les deux étages de conversion 1 et 2 et les deux blocs de modulation 201 et 202 de l'étage 1.

Les mélangeurs différentiels utilisés sont constitués chacun de deux transistors. Les transistors utilisés sont préférentiellement des transistors de technologie MOS, ce qui permet d'obtenir une linéarité élevée du mélangeur et donc de la structure globale.

Aux mélangeurs 103 à 106 de la figure 3, correspondent les transistors 203A à 206A et 203B à 206B de la figure 4, et au mélangeur 110 de la figure 3, correspond les transistors 210A et 210B de la figure 4.

Afin de pouvoir obtenir en sortie des blocs 201 et 202 les signaux convertis IF1C et IF1C_b, les signaux en bande de base et les signaux porteurs fournis à ces deux blocs sont combinés comme suit :
- les transistors 203A et 203B reçoivent sur leur drain, respectivement, le signal en phase en bande de base bbl et le signal en opposition en bande de base bbl_b, et sur leur grille, respectivement, le signal porteur en phase IF1I et le signal porteur en opposition IF1I_b, leur source étant reliée 213 au signal modulé IF1Im ;
- les transistors 204A et 204B reçoivent sur leur drain, respectivement, le signal en quadrature en bande de base bbQ et le signal en opposition de quadrature en bande de base bbQ_b, et sur leur grille, respectivement, le signal porteur en quadrature IF1Q et le signal porteur en opposition de quadrature IF1Q_b, leur source étant reliée 214 au signal modulé IF1Qm ;
- les transistors 205A et 205B reçoivent sur leur drain, de manière inversée par rapport aux transistors 203A et 203B, respectivement, le signal en opposition en bande de base bbl_b et le signal en phase en bande de base bbl, et sur leur grille, respectivement, le signal porteur en phase IF1I et le signal porteur en opposition IF1I_b, leur source étant reliée 215 au signal modulé IF1Im_b ;
- les transistors 206A et 206B reçoivent sur leur drain, de manière inversée par rapport aux transistors 204A et 204B, respectivement, le signal en opposition de quadrature en bande de base bbQ_b et le signal en quadrature en bande de base bbQ, et sur leur grille, respectivement, le signal porteur en quadrature IF1Q et le signal porteur en opposition de quadrature IF1Q_b, leur source étant reliée 216 au signal modulé IF1Qm_b ;
- l'additionneur 207 somme les signaux modulés IF1Im et IF1Qm pour donner le signal converti IF1C et l'additionneur 208 somme les signaux modulés IF1Im_b et IF1Qm_b pour donner le signal converti IF1C_b.

Les deux signaux convertis sont fournis en entrée de l'étage 2. Le mélangeur 110 de la figure 3 correspond aux transistors 21 0A et 210B de la figure 4. Afin de ne garder en sortie de l'étage 2 que le signal modulé à la fréquence désirée, les transistors sont commandés par des signaux porteurs en phase et en opposition à la fréquence intermédiaire IF2.

Le transistor 210A reçoit sur son drain le signal converti en phase IF1C, et sur sa grille le signal porteur en phase IF2I. Le transistor 210B reçoit sur son drain le signal converti en opposition IF2C_b et sur sa grille le signal porteur en opposition IF2I_b. Les sources des transistors 210A et 210B sont reliées 220 au signal modulé haute fréquence HF_M, la fréquence HF de ce signal étant égale à la somme de la fréquence intermédiaire IF1 des signaux convertis et à la fréquence intermédiaire IF2 des signaux porteurs de l'étage 2.

La figure 5 est un exemple des moyens utilisés pour produire les signaux porteurs aux fréquences intermédiaires IF1 et IF2. Un générateur de signaux 301 à la fréquence intermédiaire IF2 fournit en sortie un signal en phase IF21, lequel est directement fourni à l'étage 2 du modulateur, des moyens étant prévus pour déphaser de 180° le signal en phase et ainsi obtenir les signaux en phase IF2I et en opposition IF2I_b. Le signal IF2I délivré par le générateur 301 est également fourni à un diviseur de fréquence en quadrature 302. Ce diviseur fournit en sortie des signaux en phase IF1I et en quadrature IF1Q à une fréquence intermédiaire IF1 deux fois moins élevée que la fréquence intermédiaire IF2. Ces signaux IF1I et IF1Q sont fournis à l'étage 1 du modulateur comme signaux porteurs, là aussi il est prévu des moyens pour générer les signaux en opposition.

Dans l'exemple de la téléphonie mobile, la fréquence de modulation est de 900 MHz. Il sera donc intéressant de prendre un générateur de signaux à 600 MHz et un diviseur de fréquence par deux. La fréquence intermédiaire IF2 sera donc de 600 MHz, la fréquence intermédiaire IF1 sera deux fois plus petite soit de 300 MHz. Ce qui donne un signal modulé haute fréquence HF en sortie de 900 MHz.

Il est bien entendu que la description n'est donnée qu'à titre d'exemple et que d'autres modes de réalisation, en particulier dans les moyens de génération des signaux opposés comme le bloc miroir de modulation (102, 202), peuvent faire l'objet de la présente invention.

## Revendications

1. Modulateur à double conversion, comprenant un premier étage de conversion (1) formé d'un premier bloc de modulation (101; 201),
- recevant en entrée des signaux quadriphasés en bande de base constitués par un premier signal en phase (bbl), un deuxième signal en opposition de phase (bbl_b), un troisième signal en quadrature (bbQ) et un quatrième signal en opposition de quadrature (bbQ_b),
- commandé par quatre signaux porteurs quadriphasés à une première fréquence intermédiaire (IF1) constitués par un premier signal porteur en phase (IF1I), un deuxième signal porteur en opposition de phase (IF1I_b), un troisième signal porteur en quadrature (IF1Q) et un quatrième signal porteur en opposition de quadrature (IF1Q_b), et
- délivrant en sortie un premier signal converti (IF1C) à ladite première fréquence intermédiaire (IF1),
**caractérisé en ce que** ledit premier étage (1) est formé en outre d'un deuxième bloc de modulation (102; 202), similaire audit premier bloc,
- recevant en entrée lesdits premier, deuxième, troisième et quatrième signaux en bande de base (bbl, bbl_b, bbQ, bbQ_b),
- commandé par lesdits premier, deuxième, troisième et quatrième signaux porteurs (IF1I, IF1I_b, IF1Q, IF1Q_b) à ladite première fréquence intermédiaire (IF1) et
- délivrant en sortie un deuxième signal converti (IF1C_b), en opposition de phase audit premier signal converti, à ladite première fréquence intermédiaire (IF1),
et **en ce que** le modulateur comprend en outre un deuxième étage de conversion (2),
- recevant en entrée lesdits premier et deuxième signaux convertis (IF1C, IF1C_b) à ladite première fréquence intermédiaire (IF1),
- commandés par deux autres signaux porteurs à une deuxième fréquence intermédiaire (IF2), constitués par un cinquième signal porteur (IF21) en phase et un sixième signal porteur (IF2I_b) en opposition de phase, et
- délivrant en sortie un signal haute fréquence (HF_M), ladite haute fréquence (HF) correspondant à la somme desdites première et deuxième fréquences intermédiaires (IF1 + IF2).

2. Modulateur à double conversion selon la revendication 1, **caractérisé en ce que** lesdits premier, respectivement, deuxième blocs (101, 102) dudit premier étage (1) comprennent des premier (103) et deuxième (104) mélangeurs différentiels, respectivement, des troisième (105) et quatrième (106) mélangeurs différentiels,
**en ce que** lesdits premier (103) et deuxième (104) mélangeurs fournissent en sortie, respectivement, des premier (IF1Im) et deuxième (IF1Qm) signaux modulés à ladite première fréquence intermédiaire (IF1), lesdits premier et deuxième signaux modulés étant sommés en sortie dudit premier bloc (101) pour obtenir ledit premier signal converti (IF1C),
**en ce que** lesdits troisième (105) et quatrième (106) mélangeurs différentiels fournissent en sortie, respectivement, des troisième (IF1Im_b) et quatrième (IF1Qm_b) signaux modulés à ladite première fréquence intermédiaire (IF1), lesdits troisième et quatrième signaux modulés étant sommés en sortie dudit deuxième bloc (102) pour obtenir ledit deuxième signal converti (IF1C_b), et
**en ce que** ledit deuxième étage de conversion (2) est constitué d'un cinquième mélangeur différentiel (110).

3. Modulateur à double conversion selon la revendication 1 ou 2, **caractérisé en ce que** lesdits cinquième (IF2I) et sixième (IF2I_b) signaux porteurs à la deuxième fréquence intermédiaire (IF2) sont directement générés par un générateur (301) de signaux à ladite deuxième fréquence intermédiaire et **en ce que** lesdits premier, deuxième, troisième et quatrième signaux porteurs à la première fréquence intermédiaire (IF1) sont obtenus après division par deux de la fréquence dans un diviseur en quadrature (302) placé en sortie dudit générateur de signaux, ladite deuxième fréquence intermédiaire (IF2) étant deux fois plus importante que ladite première fréquence intermédiaire (IF1).

## Patentansprüche

1. Doppelumsetzungsmodulator, der eine erste Umsetzungsstufe (1) umfasst, die aus einem ersten Modulationsblock (101; 201) gebildet ist, der
- am Eingang vierfach phasenverschobene Grundbandsignale empfängt, die aus einem ersten, phasengleichen Signal (bbl), einem zweiten Signal mit entgegengesetzter Phase (bbI_b), einem dritten um 90 Grad phasenverschobenen Signal (bbQ) und einem vierten entgegengesetzt um 90 Grad phasenverschobenen Signal (bbQ_b) gebildet sind,
- durch vier vierfach phasenverschobene Trägersignale mit einer ersten Zwischenfrequenz (IF1) gesteuert wird, die aus einem ersten, phasengleichen Trägersignal (IF1I), einem zweiten Trägersignal mit entgegengesetzter Phase (IF1I_b), einem dritten Trägersignal (IF1Q) mit um 90 Grad verschobener Phase und einem vierten Trägersignal mit entgegengesetzt um 90 Grad verschobener Phase (IF1Q_b) gebildet sind, und
- am Ausgang ein erstes umgesetztes Signal (IF1C) mit der ersten Zwischenfrequenz (IF1) liefert,
**dadurch gekennzeichnet, dass** die erste Stufe (1) außerdem aus einem dem ersten Block ähnlichen zweiten Modulationsblock (102; 202) gebildet ist, der
- am Eingang das erste, das zweite, das dritte und das vierte Grundbandsignal (bbl, bbI_b, bbQ, bbQ_b) empfängt,
- durch das erste, das zweite, das dritte und das vierte Trägersignal (IF1I, IF1I_b, IF1IQ, IFQ_b) mit der ersten Zwischenfrequenz (IF1) gesteuert wird und
- am Ausgang ein zweites umgesetztes Signal (IF1C_b) mit einer zu der Phase des ersten umgesetzten Signals entgegengesetzten Phase und mit der ersten Zwischenfrequenz (IF1) liefert,
und dass der Modulator außerdem eine zweite Umsetzungsstufe (2) umfasst, die
- am Eingang das erste und das zweite umgesetzte Signal (IF1C, IF1C_b) mit der ersten Zwischenfrequenz (IF1) empfängt,
- durch zwei weitere Trägersignale mit einer zweiten Zwischenfrequenz (IF2) gesteuert wird, die durch ein fünftes, phasengleiches Trägersignal (IF2I) und ein sechstes Trägersignal (IF2I_b) mit entgegengesetzter Phase gebildet sind, und
- am Ausgang ein Hochfrequenzsignal (HF_M) liefert, wobei die Hochfrequenz (HF) der Summe aus der ersten und der zweiten Zwischenfrequenz (IF1 + IF2 entspricht.

2. Doppelumsetzungsmodulator nach Anspruch 1, **dadurch gekennzeichnet, dass** der erste bzw. der zweite Block (101, 102) der ersten Stufe (1) einen ersten (103) und einen zweiten (104) differentiellen Mischer bzw. einen dritten (105) und einen vierten (106) differentiellen Mischer umfassen, dass der erste (103) und der zweite (104) differentielle Mischer am Ausgang ein erstes (IF1lm) bzw. ein zweites (IF1Qm) moduliertes Signal mit der ersten Zwischenfrequenz (IF1) liefern, wobei das erste und das zweite modulierte Signal am Ausgang des ersten Blocks (101) summiert werden, um das erste umgesetzte Signal (IF1C) zu erhalten,
dass der dritte (105) und der vierte (106) differentielle Mischer am Ausgang ein drittes (IF1Im_b) bzw. ein viertes (IF1Qm_b) moduliertes Signal mit der ersten Zwischenfrequenz (IF1) liefern, wobei das dritte und das vierte modulierte Signal am Ausgang des zweiten Blocks (102) summiert werden, um das zweite umgesetzte Signal (IF1C_b) zu erhalten, und
dass die zweite Umsetzungsstufe (2) aus einem fünften differentiellen Mischer (110) gebildet ist.

3. Doppelumsetzungsmodulator nach Anspruch 1 oder 2, **dadurch gekennzeichnet, dass** das fünfte (IF2I) und das sechste (IF2I_b) Trägersignal mit der zweiten Zwischenfrequenz (IF2) direkt durch einen Signalgenerator (301) mit der zweiten Zwischenfrequenz erzeugt werden und dass das erste, das zweite, das dritte und das vierte Trägersignal mit der ersten Zwischenfrequenz (IF1) nach einer Teilung durch 2 der Frequenz in einem Quadraturteiler (302), der am Ausgang des Signalgenerators angeordnet ist, erhalten werden, wobei die zweite Zwischenfrequenz (IF2) zweimal größer als die erste Zwischenfrequenz (IF1) ist.

## Claims

1. Double up-conversion modulator, including a first up-conversion stage (1), formed of a first modulation unit (101; 201),
- receiving respectively at first, second, third and fourth inputs quadriphased baseband signals formed by a first in-phase signal (bbl), a second in-phase opposition signal (bbl_b), a third in quadrature signal (bbQ) and a fourth in quadrature opposition signal (bbQ_b),
- controlled by four quadriphased carrier signals at a first intermediate frequency (IF1) formed by a first in-phase carrier signal (IF1I), a second in-phase opposition carrier signal (IF1I_b), a third in quadrature carrier signal (IF1Q) and a fourth in quadrature opposition carrier signal (IF1Q_b), and
- delivering at one output a first up-converted signal (IF1C) at said first intermediate frequency (IF1),
**characterised in that** said first stage (1) is further formed of a second modulation unit (102; 202) similar to said first unit;
- receiving respectively at first, second, third and fourth inputs said first, second, third and fourth baseband signals (bbl, bbl_b, bbQ, bbQ_b),
- controlled by said first, second, third and fourth carrier signals (IF1I, IF1L_b, IF1Q, IF1Q_b) at said first intermediate frequency (IF1), and
- delivering at one output a second up-converted signal (IF1C_b), in phase opposition with respect to said first up-converted signal, at said first intermediate frequency (IF1),
and **in that** the modulator further includes a second up-conversion stage (2),
- receiving respectively at a first and a second inputs said first and second up-converted signals (IF1C, IF1C_b), at said first intermediate frequency (IF1),
- controlled by two other carrier signals at a second intermediate frequency (IF2), formed by a fifth in-phase carrier signal (IF2I) and a sixth in phase opposition carrier signal (IF2I_b), and
- delivering at one output a high frequency signal (HF_M), said high frequency (HF) corresponding to the sum of said first and second intermediate frequencies (IF1 +IF2).

2. Double up-conversion modulation according to claim 1, **characterised in that** said first, respectively, second modulation units (101, 102) of said first up-conversion stage (1) include first (103) and second (104) differential mixers, respectively, third (105) and fourth (106) differential mixers,
**in that** said first (103) and second (104) mixers provide at one output, respectively, first (IF1Im) and second (IF1Qm) modulated signals at said first intermediate frequency (IF1), said first and second modulated signals being added at the output of said first unit (101) to obtain said first up-converted signal (IF1C),
**in that** said third (105) and fourth (106) differential mixers provide at one output, respectively, third (IF1m_b) and fourth modulated (IFQm_b) signals at said first intermediate frequency (IF1), said third and fourth modulated signals being added at one output of said second unit (102) to obtain said second up-converted signal (IF1C_b), and
**in that** said second up-conversion stage (2) is formed of a fifth differential mixer (110).

3. Double up-conversion modulator according to claim 1 or 2, **characterised**
**in that** said fifth (IF2I) and sixth (IF2I_b) carrier signals at the second intermediate frequency (IF2) are directly generated by a signal generator (301) at said second intermediate frequency and in that said first, second, third and fourth carrier signals at the first intermediate frequency (IF1) are obtained after dividing the frequency by two in an in quadrature divider (302) placed at one output of said signal generator, said second intermediate frequency (IF2) being twice as high as said first intermediate frequency (IF1).
